# EUROPÄISCHE PATENTSCHRIFT

(11) **EP 0 902 979 B1**
(45) Veröffentlichungstag und Bekanntmachung des Hinweises auf die Patenterteilung: **14.07.2010**
(21) Anmeldenummer: 97923788.0
(22) Anmeldetag: 07.05.1997
(51) Int. Cl.: H01L 29/74, H01L 29/10

(54) **THYRISTOR MIT INTEGRIERTEM DU/DT-SCHUTZ**
THYRISTOR WITH INTEGRATED DU/DT PROTECTION
THYRISTOR A PROTECTION DU/DT INTEGREE

(30) Priorität: 20.05.1996 DE 19620184; 06.12.1996 DE 19650763
(43) Veröffentlichungstag der Anmeldung: 24.03.1999
(73) Patentinhaber: Infineon Technologies AG, 85579 Neubiberg (DE)
(72) Erfinder: RUFF, Martin, D-85591 Vaterstetten (DE); SCHULZE, Hans-Joachim, D-85521 Ottobrunn (DE); PFIRSCH, Frank, D-81545 München (DE)
(74) Vertreter: Bauer Vorberg Kayser Patentanwälte
(86) Internationale Anmeldenummer: PCT/DE1997/000927
(87) Internationale Veröffentlichungsnummer: WO 1997/044827

(56) Entgegenhaltungen:
- EP-A- 0 062 100
- EP-A- 0 219 995
- EP-A- 0 637 848
- WO-A-86/00469
- FR-A- 2 377 095
- PATENT ABSTRACTS OF JAPAN vol. 95, no. 8, 29.September 1995 & JP 07 122728 A (TOSHIBA CORP), 12.Mai 1995,
- PATENT ABSTRACTS OF JAPAN vol. 9, no. 95 (E-310), 24.April 1985 & JP 59 220970 A (MEIDENSHA KK), 12.Dezember 1984,

## Beschreibung

### 1. Einleitung

Ein Thyristor zündet bereits vor dem Erreichen der statischen Kippspannung U_{BO}, wenn die zeitliche Änderung dU/dt der zwischen seinen Anschlüssen angelegten Spannung U einen für den jeweiligen Thyristor spezifischen Maximalwert übersteigt. Ausgelöst wird diese unter Umständen zur Zerstörung des Thyristors führende Fehlzündung durch den Aufbau der Raumladungszone am p-Basis/n-Basis-Übergang und dem daraus resultierenden, den Sperrstrom verstärkenden Verschiebungsstrom I_{d} = C_{d} dU/dt (C_{d}: spannungsabhängige Raumladungskapazität des pn-Übergangs). Mit Hilfe von Kathoden-Emitterkurzschlüssen läßt sich die dU/dt-Festigkeit eines Thyristors erheblich verbessern, da ein Großteil des kapazitiven Verschiebungsstroms I_{d} im Halbleiterkörper nicht mehr über den kathodenseitigen pn-Übergang, sondern von der Basis direkt zur Kathode fließt. Der kritische Wert der Spannungssteilheit entsprechend aufgebauter Thyristoren beträgt typischerweise mehrere 1000 V/µs.

### 2. Stand der Technik

Leistungsthyristoren müssen mit Emitterkurzschlüssen versehen werden, um den Anforderungen hinsichtlich der dU/dt-Belastbarkeit zu genügen. Emitterkurzschlüsse leiten allerdings einen Teil des Gatestroms direkt zur Kathode ab, was sich nachteilig auf die Zündempfindlichkeit des Thyristors auswirkt. Zur Lösung dieses Problems wird unter anderem vorgeschlagen, die Struktur des Gates zu optimieren, die vom kapazitiven Strom I_{d} hervorgerufene Potentialänderung der kathodenseitigen Basis zu kompensieren und die optische Zündempfindlichkeit des Thyristors durch mehrere hintereinander geschaltete Amplifying Gate-Stufen zu erhöhen (s. beispielsweise [1] und [2].

Aus der JP 59 220970 A ist ein Thyristor bekannt, in dessen kathodenseitiger Basis eine Widerstandszone und eine daran angrenzende, p-dotierte Zone zwischen einem n-dotierten Hilfsemitter und der anodenseitigen Basis angeordnet sind.

Die EP 0 062 100 A2 zeigt einen Thyristor mit einer zündstufenstruktur, die zwei Hilfsemitter umfasst. Der der Zündelektrode nächstliegende Hilfsemitter erstreckt sich tief in die kathodenseitige Basis hinein, so dass sich deren Wiederstand unterhalb dieses Hilfsemitters erhöht.

Aus der FR 2 377 095 A ist ein Thyristor bekannt, der Abschnitte mit erhöhter Dotierung aufweist, die in lateraler Richtung an Abschnitte mit geringerer Dotierung angrenzen. Die Abschnitte mit geringerer Dotierung weisen bei einer Projektion senkrecht zur Kathodenebene rechteckige Projektionsflächen auf.

In der JP 07 122728 A ist ein Thyristor mit einem Hauptthyristorabschnitt, einem Pilotthyristor und einer Zündstufenstruktur beschrieben. Im Bereich des Pilotthyristors und der Zündstufenstruktur ist die Dotierung der kathodenseitigen Basis gegenüber der Dotierung der kathodenseitigen Basis im Bereich des Hauptthyristors reduziert.

Die WO 86/00469 A zeigt einen Hauptthyristor, dessen kathodenseitige Basis eine Widerstandszone aufweist, die sich über die gesamte Dicke der kathodenseitigen Basis bis zur Oberfläche des Halbleiterköpers erstreckt.

P. Taylor: "Thyristor Design and Realisation", John Wiley and Sons Ltd., 1987, Seiten 151 bis 152 mit Figur 4.39, beschreibt einen Thyristor mit einer Durchbruchstruktur, in deren Bereich die Vorderseite des Halbleiterkörpers ausgespart ist. Die seitliche Begrenzung der Aussparung ist durch gekrümmte Abschnitte der kathodenseitigen Basis gegeben.

### 3. Ziele und Vorteile der Erfindung

Die Erfindung hat einen insbesondere lichtzündbaren und BOD-geschützten Thyristor mit integriertem dU/dt-Schutz zum Gegenstand. Der Thyristor soll derart aufgebaut sein, daß er im Falle einer zu großen dU/dt-Belastung in Kipprichtung nicht unkontrolliert im Bereich der Kathodenfläche oder des Randabschlusses zündet, Ein Thyristor mit den in Patentanspruch 1 angegebenen Merkmalen besitzt diese Eigenschaft. Die abhängigen Ansprüche betreffen vorteilhafte Ausgestaltungen und Weiterbildungen des Thyristors.

Unabhängig von der Art der zündung (elektrische oder optische Ansteuerung, dU/dt-Triggerung) wird das Zündverhalten eines Thyristors in entscheidender weise vom Schichtwiderstand der kathodenseitigen Basis beeinflußt. Die Erfindung nutzt diese Eigenschaft, um den durch eine zu große dU/dt- Belastung hervorgerufenen Zündvorgang gezielt in den Zentralbereich des Thyristors zu verlagern. Da das von der Zündung betroffene Volumen immer innerhalb des durch den ersten Hilfsthyristor begrenzten Bereichs liegt, kann sich das Plasma, wie bei einer gesteuerten zündung, großflächig und gleichförmig in radialer Richtung ausbreiten, ohne daß die Stromdichte kritische Werte erreicht.

### 4. Zeichnung

Die Erfindung wird im folgenden anhand der Zeichnung erläutert. Es zeigen
- Figur 1: die Zündstruktur eines BOD-geschützten lichtzündbaren Thyristors im Querschnitt;
- Figur 2: die BOD-Struktur des Thyristors im Querschnitt;
- Figur 3: den Halbleiterkörper des Thyristors nach Ausführung einzelner Schritte des Verfahrens zur Herstellung ei- ner ringförmigen Zone erhöhten Widerstandes in der kathodenseitigen Basis.

### 5. Beschreibung eines Ausführungsbeispiels

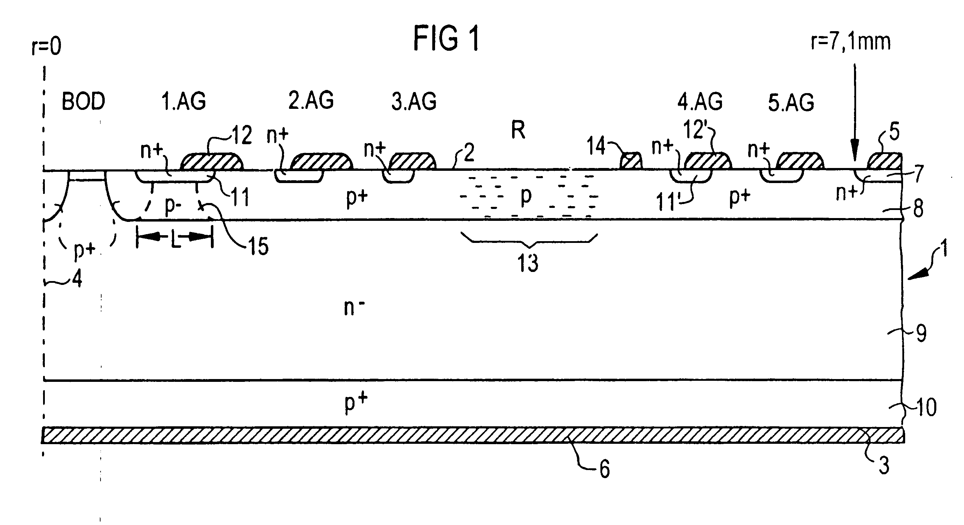

Der in Figur 1 im Querschnitt dargestellte, mit einer BOD (breakover-diode)-Struktur ausgestattete lichtzündbare Thyristor besitzt einen rotationssymmetrischen Aufbau bezüglich der senkrecht auf den beiden Hauptflächen 2/3 des Halbleiterkörpers 1 stehenden Achse 4. Während die obere Hauptfläche 2 des scheibenförmigen Halbleiterkörpers 1 die randseitig verlaufende, mit sogenannten Emitterkurzschlüssen versehene Kathodenmetallisierung 5 trägt, ist seine rückseitige Hauptfläche 3 vollständig mit einer als Anode dienenden Metallisierung 6 beschichtet. Der aus Silizium bestehende Halbleiterkörper 1 weist mehrere unterschiedlich dotierte, jeweils durch Raumladungszonen voneinander getrennte Bereiche 7 -10 auf. Diese Bereiche unterschiedlicher Leitfähigkeit bilden den n⁺-dotierten kathodenseitigen Emitter 7, die p-dotierte Basis 8, die nur schwach elektronenleitende anodenseitige Basis 9 sowie den von der Anodenmetallisierung 6 kontaktierten p⁺-Emitter 10 des Thyristors.

Die mit AG (Amplifying Gate) bezeichneten, radial innerhalb der Kathodenmetallisierung 5 angeordneten Hilfsthyristoren dienen als Treiberstufen für den Hauptthyristor. Sie weisen jeweils einen in der kathodenseitigen Basis 8 eingebetteten, n⁺-dotierten Hilfsemitter 11/11' und eine sowohl den Hilfsemitter 11/11' als auch die Basis 8 kontaktierende Metallisierung 12/12' auf. Die sich über den n⁺-dotierten Bereich 11/11' erstreckende Metallisierung 12/12' hat die Funktion eines Kurzschlußemitters, der ein unerwünschtes Zünden des jeweiligen Hilfsthyristors bei großen Spannungssteilheiten dU/dt wirkungsvoll unterdrückt.

In einer die inneren drei Hilfsthyristoren (1.-3. AG) ringförmig umschließenden Zone 13 der kathodenseitigen Basis 8 ist die Dotierstoffkonzentration gegenüber den lateral angrenzenden Bereichen verringert. Diese Ringzone 13 wirkt als Widerstand R, der den in der Basis 8 radial nach außen fließenden Zündstrom auf einen vorgegebenen Maximalwert begrenzt und so die Belastung der Struktur während des Einschaltvorgangs vermindert (s. beispielsweise [2] oder [3]). Am Metallring 14 können die vom angrenzenden Hilfsemitter 11' in die kathodenseitige Basis 8 injizierten Elektronen rekombinieren, so daß der Widerstand R beim Durchschalten des Thyristors keiner Modulation unterliegt.

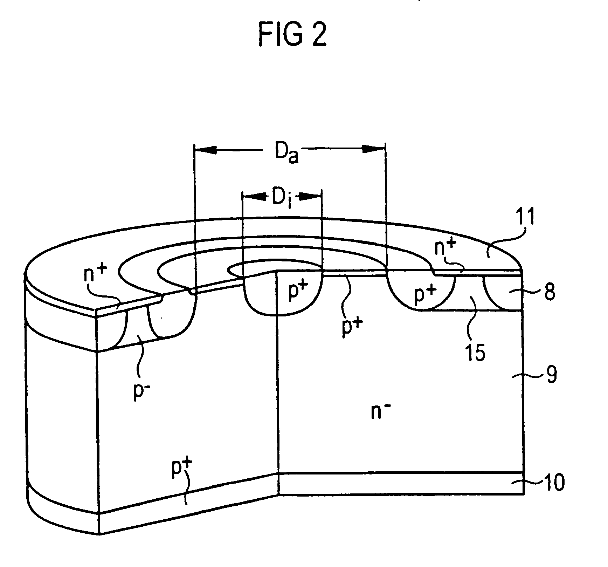

Die im Zentrum des Thyristors vorhandene, in [4] näher beschriebene und in Figur 2 vergrößert dargestellte BOD-Struktur dient dem Überspannungsschutz. Ihre lateralen Abmessungen sind mit Dᵢ = 350 µm und Dₐ = 550 µm so bemessen, daß die Durchbruchsspannung bei Zimmertemperatur T = 23°C etwa U_{BOD} ≈ 7,7 kV beträgt.

Um einen durch eine zu große dU/dt-Belastung hervorgerufenen Zündvorgang gezielt in den Zentralbereich des Thyristors zu verlagern, besitzt die kathodenseitige Basis 8 in einer unterhalb des n⁺-dotierten Bereichs 11 des ersten Hilfsthyristors 1.AG liegenden Ringzone 15 einen erhöhten Widerstand. Da die Breite L und der durch die Dotierstoffkonzentration gegebene Schichtwiderstand R_{□} der Ringzone 15 sowohl die zur Zündung des ersten Hilfsthyristors erforderliche minimale Strahlungsintensität als auch dessen dU/dt-Belastbarkeit entscheidend beeinflußt, läßt sich durch eine geeignete Dimensionierung dieser Parameter sicherstellen, daß die zentral gelegene Thyristorstruktur die größte dU/dt-Empfindlichkeit des Systems aufweist und sie demzufolge bei Überschreitung eines kritischen Wertes der Spannungssteilheit zuerst zündet. Der Schichtwiderstand R_{□} der etwa 200 - 600 µm breiten Ringzone 15 beträgt typischerweise R_{□} ≈ 2000 - 4000 Ω_{□}. Er ist damit um einen Faktor 10-20 größer als der Schichtwiderstand des angrenzenden Basisbereichs (R_{□} (p⁺) ≈ 200 - 400 Ω_{□}).

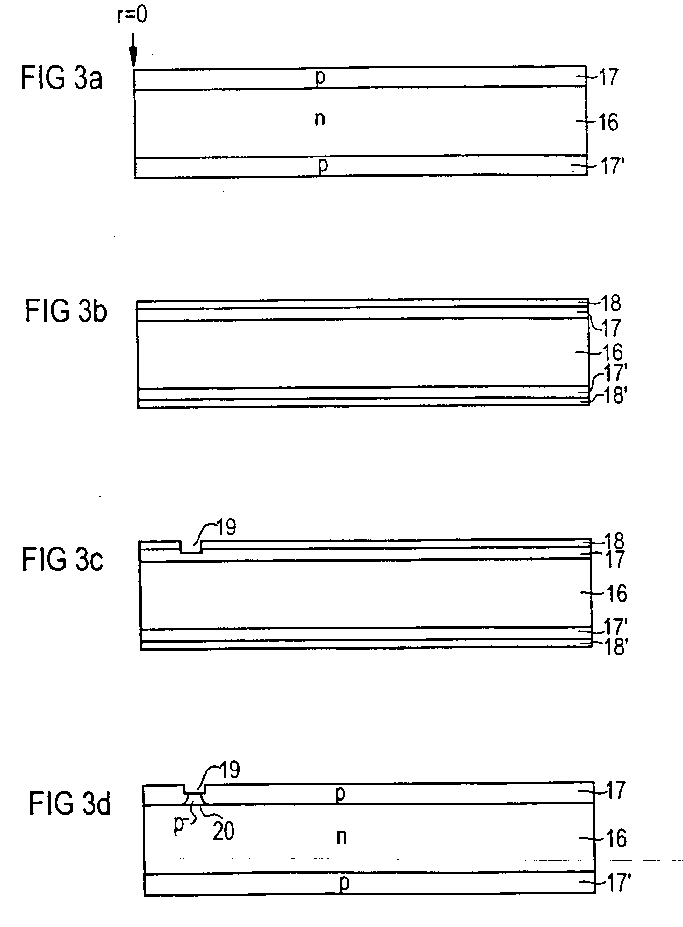

Ausgangspunkt des Verfahrens zur Herstellung der Ringzone 15 erhöhten Widerstandes in der kathodenseitigen Basis 8 ist die in Figur 3a dargestellte Siliziumscheibe (n-leitend), welche zwei aluminiumdotierte und damit p-leitende Bereiche 17/17' aufweist. Sie wird beidseitig im Vakuum mit einer nur etwa 5 µm tief reichenden, aber vergleichsweise hochdotierten Al-Belegung 18/18' versehen. Dieser etwa 2 Stunden dauernde Prozeß findet bei einer Temperatur T = 1060°C statt. Anschließend entfernt man die obere Al-Belegung 18 im Bereich der späteren Widerstandszone, wobei eine photolithographisch strukturierte Maske die Lage und Breite des herausgeätzten Grabens 19 definiert. Das Eintreiben der noch verbleibenden Al-Belegungen 18/18' in die darunterliegenden Schichten 17, 17' erfolgt bei einer Temperatur T = 1240°C. Während dieses etwa 20 Stunden in Anspruch nehmenden Vorgangs bildet sich unterhalb des Grabens 19 eine ringförmige Zone 20 verminderter Dotierstoffkonzentration. In Abweichung dieses Verfahrens ist es selbstverständlich auch möglich, die Ringzone 20 erhöhten Widerstandes durch eine maskierte Borimplantation zu erzeugen.

### 6. Ausgestaltungen und Weiterbildungen

Die Erfindung beschränkt sich selbstverständlich nicht auf das oben beschriebene Ausführungsbeispiel. So ist es ohne weiteres möglich, den vorgeschlagenen dU/dt-Schutz auch in einem mit einer konventionellen Gateelektrode ausgestatteten oder einem keine BOD-Struktur aufweisenden Thyristor vorzusehen bzw. die Zone erhöhten Widerstandes unterhalb eines anderen zentral gelegenen Hilfsthyristors zu erzeugen.

### 7. Literatur

[1] Paul D. Taylor: "Thyristor Design and Realization"; John Wiley & Sons (1987), S. 133-141
[2] IEEE Transactions on Electron Devices, Vol. ED-30, No. 7, July 1983, S. 816-824
[3] US-A-5,204,273
[4] EP-0 572 826 A1

## Patentansprüche

1. Thyristor mit
a) in einem Halbleiterkörper (1) aufeinanderfolgend einem kathodenseitigen Emitter (7) eines ersten Leitungstyps,
einer kathodenseitigen Basis (8) eines zweiten Leitungstyps,
einer anodenseitigen Basis (9) des ersten Leitungstyps und einem anodenseitigen Emitter (10) des zweiten Leitungstyps,
b) einer auf den kathodenseitigen Emitter (7) aufgebrachten Kathodenmetallisierung (5) und
einer auf den anodenseitigen Emitter (10) aufgebrachten Anodenmetallisierung (6),
c) mehreren konzentrisch angeordneten ringförmigen Hilfsthyristoren (1.-5. AG), von denen jeder einen in der kathodenseitigen Basis (8) eingebetteten Hilfsemitter (11, 11') umfasst, der durch einen ringförmigen Bereich des ersten Leitungstyps gebildet und so angeordnet ist, daß der kathodenseitige Emitter (7) außerhalb des von dem Hilfsemitter (11, 11') eingeschlossenen Bereichs liegt,
d) einer die kathodenseitige Basis (8) kontaktierenden Metallisierung (12) der Hilfsemitter (11),
e) einer Ringzone (15), die unterhalb des innersten Hilfsemitters (11) zwischen dem innersten Hilfsemitter (11) und der anodenseitigen Basis (9), jedoch nicht unterhalb eines der anderen Hilfsemitter angeordnet und durch einen ringförmigen Bereich in der kathodenseitigen Basis (8) gebildet ist, in dem die Konzentration der Dotierung gegenüber den lateral angrenzenden Bereichen der kathodenseitigen Basis (8) vermindert ist, und
f) einer im Zentralbereich des Halbleiterkörpers (1) angeordneten, optisch oder elektrisch angesteuerten Zündstruktur.

2. Thyristor nach Anspruch 1,
bei dem die Konzentrationen des Dotierstoffes so gewählt sind, daß der elektrische Schichtwiderstand in der Ringzone (15) um einen Faktor 5 bis 20 größer ist als der elektrische Schichtwiderstand der lateral angrenzenden Bereiche der kathodenseitigen Basis.

3. Thyristor nach Anspruch 1 oder 2,
bei dem die Ringzone (15) eine Breite von 200 µm bis 600 µm aufweist.

4. Thyristor nach einem der Ansprüche 1 bis 3,
bei dem in einem von der Ringzone (15) umschlossenen Zentralbereich des Halbleiterkörpers (1) eine BOD-Struktur integriert ist.

5. Thyristor nach Anspruch 4,
bei dem die BOD-Struktur gebildet ist durch
- den Hilfsemitter (11),
- die Ringzone (15),
- einen in der Schicht der kathodenseitigen Basis zum Zentrum hin an die Ringzone (15) angrenzenden ringförmigen Bereich welcher durch den zweiten Leitungstyp hoch dotiert ist,
- einen zum Zentrum hin an diesen ringförmigen Bereich
angrenzenden weiteren ringförmigen Bereich geringerer Dicke welcher auch mit den zweiten Leitungstyp hoch dotiert ist, der ebenfalls an die anodenseitige Basis (9) angrenzt, und
- einen an diesen weiteren ringförmigen Bereich und an die anodenseitige Basis angrenzenden zentralen Bereich welcher mit dem zweiten Leitungstyp hoch dotiert ist und von etwa der Dicke der kathodenseitigen Basis ist.

6. Thyristor nach Anspruch 1,
bei dem zwischen zwei Hilfsthyristoren eine weitere Ringzone (13) erhöhten elektrischen Widerstandes in der kathodenseitigen Basis (8) lokalisiert ist.

## Claims

1. A thyristor with,
a) in successive order in a semiconductor body (1),
an emitter (7) of a first type of line, located on the cathode side,
a base (8) of a second type of line, located on the cathode side,
a base (9) of said first type of line, located on the anode side,
an emitter (10) of said second type of line, located on the anode side,
b) a cathode metal-plating (5) applied to the emitter (7) located on the cathode side and
an anode metal-plating (6) applied to the emitter (10) located on the anode side,
c) several annular auxiliary thyristors (1. - 5. AG), disposed concentrically, each of which incorporating an auxiliary emitter (11, 11') embedded in said base (8) located on the cathode side, said auxiliary emitter being formed by an annular region of said first type of line and being disposed so that the emitter (7) located on the cathode side is located outside of the region enclosed by the auxiliary emitter (11, 11'),
d) a metal-plating (12) of the auxiliary emitters (11) contacting the base (8) located on the cathode side,
e) an annular zone (15) that is disposed underneath the innermost auxiliary emitter (11) between said innermost auxiliary emitter (11) and the base (9) located on the anode side, but not underneath one of the other auxiliary emitters and that is formed by an annular region in the base (8) located on the cathode side in which the concentration of the doping is reduced with respect to the laterally adjoining regions of the base (8) located on the cathode side, and
f) an ignition structure disposed in the central region of the semiconductor body (1) and controlled optically or electrically.

2. The thyristor as set forth in claim 1,
wherein the concentrations of the doping substance are chosen so that the electric sheet resistance in the annular zone (15) is greater by a factor of 5 to 20 than the electric sheet resistance of the laterally adjoining regions of the base located on the cathode side.

3. The thyristor as set forth in claim 1 or 2,
wherein the annular zone (15) comprises a width ranging from 200 µm to 600 µm.

4. The thyristor as set forth in any one of the claims 1 through 3,
wherein a BOD structure is integrated in a central region of the semiconductor body (1) that is enclosed by the annular zone (15).

5. The thyristor as set forth in claim 4,
wherein the BOD structure is formed by
- the auxiliary emitter (11),
- the annular zone (15),
- an annular region adjoining said annular zone (15) toward the center in the layer of the base located on the cathode side, said annular region being highly doped by the second type of line,
- another annular region of less thickness adjoining said annular region toward the center, said annular region being also highly doped with the second type of line and also adjoining the base (9) located on the anode side, and
- a central region adjoining said other annular region and said base located on the anode side, said central region being highly doped with said second type of line and having about the same thickness as the base located on the cathode side.

6. The thyristor as set forth in claim 1,
wherein another annular zone (13) having an increased electric resistance is localized in the base (8) located on the cathode side, between two auxiliary thyristors.

## Revendications

1. Thyristor comprenant
a) successivement, dans un corps semi-conducteur (1), un émetteur côté cathode (7) d'un premier type de conductivité, une base côté cathode (8) d'un deuxième type de conductivité, une base côté anode (9) dudit premier type de conductivité ainsi qu'un émetteur côté anode (10) dudit deuxième type de conductivité,
b) un revêtement métallique cathodique (5) appliqué sur ledit émetteur côté cathode (7) ainsi qu'un revêtement métallique anodique (6) appliqué sur ledit émetteur côté anode (10),
c) plusieurs thyristors auxiliaires annulaires (1. - 5. AG) disposés de façon concentrique qui comprennent chacun un émetteur auxiliaire (11, 11') qui est enrobé dans ladite base côté cathode (8) et qui est formé par une zone annulaire du premier type de conductivité et est disposé de manière que ledit émetteur côté cathode (7) est situé à l'extérieur de la zone entourée par ledit émetteur auxiliaire (11, 11'),
d) un revêtement métallique (12) des émetteurs (11), qui contacte ladite base côté cathode (8),
e) une zone annulaire (15) qui est disposée au-dessous de l'émetteur auxiliaire situé le plus à l'intérieur (11), entre ledit émetteur situé le plus à l'intérieur (11) et ladite base côté anode (9), mais non pas au-dessous de l'un des autres émetteurs auxiliaires, et qui est formée par une zone annulaire dans la base côté cathode (8), dans laquelle la concentration du dopage est réduite par rapport aux zones de la base côté cathode (8) qui se joignent latéralement, et
f) une structure d'amorçage disposée dans la zone centrale dudit corps semi-conducteur (1) et commandée optiquement ou électriquement.

2. Thyristor selon la revendication 1, dans lequel les concentrations du dopant sont choisies de telle manière que la résistance série électrique dans la zone annulaire (15) est plus importante d'un facteur 5 à 20 que la résistance série électrique des zones de la base côté cathode qui se joignent latéralement.

3. Thyristor selon la revendication 1 ou 2, dans lequel ladite zone annulaire (15) présente une largeur comprise entre 200 µm et 600 µm.

4. Thyristor selon l'une quelconque des revendications 1 à 3, dans lequel une zone centrale du corps semi-conducteur (1), qui est entourée par ladite zone annulaire (15), Intègre une structure BOD.

5. Thyristor selon la revendication 4, dans lequel ladite structure BOD est constituée par
- ledit émetteur auxiliaire (11),
- ladite zone annulaire (15),
- une zone annulaire qui est contiguë, dans la couche de la base côté cathode, vers le centre, à ladite zone annulaire (15) et qui est fortement dopée du deuxième type de conductivité,
- une autre zone annulaire d'épaisseur plus faible qui est contiguë, vers le centre, à cette zone annulaire et qui est, elle aussi, fortement dopée du deuxième type de conductivité et est contiguë également à ladite base côté anode (9), et par
- une zone centrale qui est contiguë à cette autre zone annulaire et à ladite base côté anode et qui est fortement dopée du deuxième type de conductivité et présente à peu près l'épaisseur de ladite base côté cathode.

6. Thyristor selon la revendication 1, dans lequel, entre deux thyristors auxiliaires, une autre zone annulaire (13) de résistance électrique élevée est localisée dans ladite base côté cathode (8).
